# EUROPEAN PATENT SPECIFICATION

(11) **EP 2 830 093 B1**
(45) Date of publication and mention of the grant of the patent: **26.09.2018**
(21) Application number: 14177592.4
(22) Date of filing: 18.07.2014
(51) Int. Cl.: H01L 25/075, H01L 33/50

(54) **LED-module with high color rendering index**
LED-Modul mit hohem Farbdarstellungsindex
Module à DEL comprenant un indice de rendu de couleur élevé

(30) Priority: 23.07.2013 AT 2392013 U
(43) Date of publication of application: 28.01.2015
(73) Proprietor: Tridonic Jennersdorf GmbH, 8380 Jennersdorf (AT)
(72) Inventor: PACHLER, Peter, 8042 Graz (AT); LEITGEB, Thomas, 8350 Fehring (AT)
(74) Representative: Rupp, Christian

(56) References cited:
- EP-A2- 1 160 883
- US-A1- 2007 223 219
- US-A1- 2009 206 322
- US-A1- 2011 273 079
- US-A1- 2012 099 303

## Description

### Background of the invention

The invention concerns a white light emitting LED-module with a CRI (Color Rendering Index) value ≥90 having a CCT (Correlated Color Temperature) in the range of 2500-8000K, preferably in the range of 2700-6500K and a corresponding LED light engine arrangement.

The ability of a light source to render the color of an object is measured using the CRI which gives a measure of how a light source makes the color of an abject appear to the human eye and how well subtle variations in color shade are revealed. CRI is a relative measure of the light source's ability to render color compared with the black body radiator. In applications where accurate color rendition is required, such as e.g. retail lighting, museum lighting and lighting of artwork, a high CRI is highly desirable in the full range of 2500K-8000K.

A possible concept of high-efficiency white light emitting LED devices with improved CRI is the three-color mixing. According to said concept the mixture of the primary colors red-green-blue (RGB) is applied to generate white light. The first approaches used monochromatic LEDs, but it was resulted in an emitted white light with a relatively low CRI, based on the narrow-band nature of the three individual emissions. A further drawback was that the used green LED was significantly less efficient than the other two components. However the advantage of the RGB solution realized using primary radiations is that the illumination system is tunable.

LED illumination systems with high CRI demand generally application of color/wavelength conversion (e.g. in form of phosphor material) of the primary radiation(s), in which some of the primary LED emission is converted into light with longer wavelengths, in particular the blue is converted into green, greenish-yellow or yellow. Said systems are not tunable since the secondary component is not independent of the primary one. The portion of the blue light generated by the LED that is not absorbed by the phosphor material combined with the light emitted by the phosphor material provides a light which appears to the human eye as being nearly white colored. WO200141215A1 describes white LED systems comprising a combination of one or more LEDs (e.g. red/green one(s)) and a phosphor converted LED consisting of a blue LED and at least one phosphor (e.g. a green one).

A further red component could be incorporated into the emitted white spectrum either as a monochromatic red LED or a red light emitting phosphor material as it was reported in e.g. EP1160883A2, WO2005030903, WO2010131133A1 and US2010177513A.

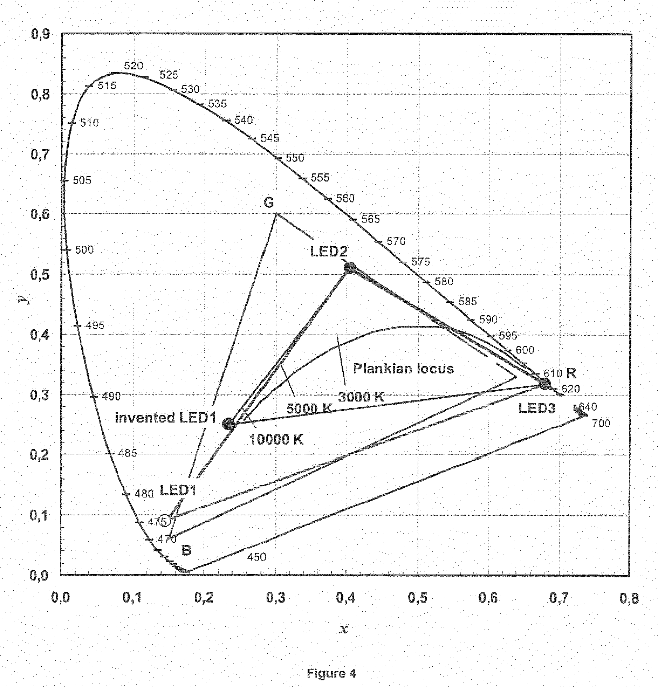

The "old" RGB solution substituting recently developed 3 (color) channel LED systems (R+White(phosphor converted blue)+B) are based on the following main system components: a color/phosphor converted blue LED with a dominant wavelength of e.g. 380-480nm (465-475nm), a further blue LED with a dominant wavelength of e.g. 380-480nm (450-460nm) and red LED with a dominant wavelength of 600-640nm (615-617.5nm). The color conversion means e.g. an inorganic phosphor such as a garnet, silicate, ortho-silicate, oxide material is applied onto a blue LED, which is resulted in a color conversion into a longer wavelength range and finally in white color emission. Said LED is usually called color/phosphor converted blue LED. One of the cited three (color) channel prior solutions is known from WO2009033642A1. The concept of the cited LED lighting system is illustrated by a so-called color triangle on the CIE 1931 Chromaticity Diagram shown by Figure 4 and the corresponding data could be found in Table 1. It means that a targeted color temperature (CCT) and/or color point described by the chromaticity coordinates inside defined triangle generated by the corner points LED1, LED2, LED3 could be reached by an arrangement using listed main elements. The drawback of said solution is that CRI values ≥90 cannot be realized in the range of 5000-6000K, which means that not the full range of 2700-6500K could be covered. With other words the CCT of white light emitting system cannot be tunned between 5000-6000K, because the CRI drops.

Document US 2011/273079 A1 discloses a lighting device which has a mixture of light emitted by a solid state light emitter comprising multiple LEDs and a lumiphor, having x, y color coordinates which are within an area on a 1931 CIE Chromaticity Diagram enclosed by four line segments having x, y coordinates of 0.45, 0.35; 0.35, 0.45; 0.12, 0.22; and 0.20, 0.075.

### Summary of the invention

Therefore, the objects of present invention are to provide a white light emitting LED-module with a 3 (color) channel solution to reach CRI values ≥90 in the full range of 2500-8000K, more preferably 2700-6500K, and at the same time keeping the complexity of the applied system (structure of the LED-module and production of it) at the same level.

These objects are achieved in accordance with the invention by means of the features of the independent claims. The dependent claims develop further the central concept of the invention in particularly advantageous manner.

According to the first aspect of the present invention there is thus provided a white light emitting LED-module, comprising:
- at least two blue LEDs,
- a red LED, mounted onto a substrate and
   a color conversion means,
   wherein the dominant wavelength of the first blue LED is between 451nm and 457nm, preferably between 452.5nm and 455nm, and the dominant wavelength of the red LED is between 610 and 620nm, preferably between 612 and 618nm, more preferably between 615nm and 617.5nm, and a color conversion means is applied at least to one of the blue LEDs.

The color rendering index (CRI) of the emitted white light can be at least 90 and the correlated color temperature (CCT) of the emitted white light is in the range of 2500K-8000K, more preferably between 2700K and 6500K.

The dominant wavelength of the second blue LED is between 440nm and 470nm, preferably between 445nm and 460nm or between 450nm and 465nm, more preferably between 450nm and 455nm or between 455nm and 460nm.

A color conversion means is applied to the first and/or to the second blue LEDs.

The value of the y chromaticity coordinate of a first color converted blue LED can be between 0.2350 and 0.2550, preferably between 0.2409 and 0.2498.

The value of the y chromaticity coordinate of a second color converted blue LED can be between 0.4750 and 0.5700, preferably between 0.4800 and 0.5650, more preferably between 0.4900 and 0.5550.

The value of the x chromaticity coordinate of a second color converted blue LED is between 0.370 and 0.440, preferably between 0.385 and 0.425, more preferably between 0.395 and 0.420.

The color point of a second color converted blue LED is located within or on the borderline of the rectangular area defined by the corner points of x=0.395, y=0.490, x=0.395, y=0.520, x=0.415, y=0.525 and x=0.415, y=0.555 on the 1931 CIE Chromaticity Diagram.

The color conversion means is selected from the group of inorganic phosphors, organic phosphors and quantum dots.

The color conversion means can show an emission peak between 505 and 580nm, more preferably between 510 and 560nm and the emission peak has a FWHM of 55-120nm, more preferably 65-110nm.

The color conversion means can have two emission peaks in the range of 505-580nm, more preferably between 510-560nm.

The color conversion means is selected from the group of garnets, aluminates, silicates, ortho-silicates, oxides, SiALONs, nitrides, oxy-nitrides.

The color conversion means has a garnet structure comprising Yttrium and/or Lutetium and/or Gadolinium and rare earth metal ion(s) as dopant(s) and/or sentisizer(s).

A mixture of color conversion means can comprise a luminophor(s) having a garnet structure based on the main components Yttrium and/or Lutetium and/or Gadolinium and rare earth metal ion(s) as dopant(s) and/or sentisizer is applied to the LEDs.

The LED-module can comprise a plurality of blue LEDs and a plurality of red LEDs.

The ratio of the first blue LEDs 1 to the second blue LEDs 2 and to red LEDs 3 can be adjusted between 2:2:1 and 4:4:1.

The blue LEDs can have a radiant power of 100-400mW.

The red LED can have a minimum luminous intensity of 15cd, preferably 17cd.

The LED-module can be a COB-module.

The LEDs can be covered by a common or individual color conversion layer(s) comprising color conversion means.

The color conversion layer(s) can comprise filler and/or scattering agent(s).

The color conversion layer can be a globe-top.

According to a further aspect of the present invention there is thus provided a method for providing a white light emitting LED-module according to claim 22.

Other features, advantages, and properties of the invention are explained below on the basis of embodiments and the figures of the accompanying drawings.

### Brief description of the drawings

Figure 1 shows an LED-module according to first embodiment of the invention.
Figure 2 shows an LED-module according to another embodiment of the invention.
Figure 3 illustrates the emission spectra of the color converted first and second blue LEDs according one embodiment of the invention.
Figure 4 shows prior art three-channel LED solutions and an invented three-channel solution according to one aspect of the invention on the CIE 1931 Chromaticity Diagram.
Figure 5 shows a rectangular area defined by color chromaticity coordinates (x, y) in which the color point of the second blue LED is located according to one aspect of the invention.
Figure 6 show emission spectra of the white light emitting LED-module according to one aspect of the invention.
Figure 7 shows a LED light engine arrangement into which an invented LED-module is intercalated.

### Detailed description of the drawings

As color conversion means applicable phosphors for LEDs known in the state of art could be used. One or more phosphors (phosphor mixtures) in organic (e.g. silicone resin(s)) or inorganic matrices (e.g. ceramic materials) could be applied to/on the LEDs. Optionally, in case of different LEDs different phosphor(s) or phosphor mixtures could be used to gain a special light color/tone and color distribution.

The color conversion means could be applied directly on the LED as e.g. a thin layer or incorporated into an encapsulation (or casting material) such as in a globe-top (e.g. dome-shaped encapsulation) covering the LED. The globe-top could cover the at least one LED or a plurality of LEDs applied onto the LED-module.

The applied LEDs could emit the same or different colors/wavelengths/spectra. The applied LED could emit the same or different spectra having the same or different dominant peak wavelength. The LEDs could be phosphor converted (e.g. white light emitting phosphor converted LEDs) or monochromatic ones (e.g. monochromatic red/blue LEDs) as well.

Applicable luminous materials are the ones emitting mainly in the green and/or yellow range (they could have additional emission or emission peak(s) in the red/orange range) known in the state of art. A luminous material with described emission characteristics could be selected from the group of silicates (Ca₃Sc₂Si₃O₁₂: Ce3+), ortho-silicates (BOSE), aluminates/garnets (YAG: Ce³⁺, (YGd)AG: Ce³⁺, LuAG: Ce³⁺), oxides (CaScO₂: Eu²⁺), SiALONs (α-SiALON: Eu²⁺, β-SiALON: Eu²⁺), nitrides (La₃Si₆N₁₁; Ce³⁺, CaAlSiN₃:Ce³⁺), oxy-nitrides (SrSi₂N₂O₂: Eu²⁺, (Ca, Sr, Ba) Si₂N₂O₂ : Eu²⁺).

The luminescent material(s) applied in the detailed embodiments according to the invention can be a garnet material comprising Yttrium and/or Lutetium and/or Gadolinium and further rare earth metal ion(s) (e.g. Ce³⁺)as dopant (s) and can have particle size of d₅₀=10-25 micron. Further a nitride(s) emitting in the green, yellowish-green or green can well substitute the garnet(s), especially La₃Si₆N₁₁: Ce³⁺ is considerable.

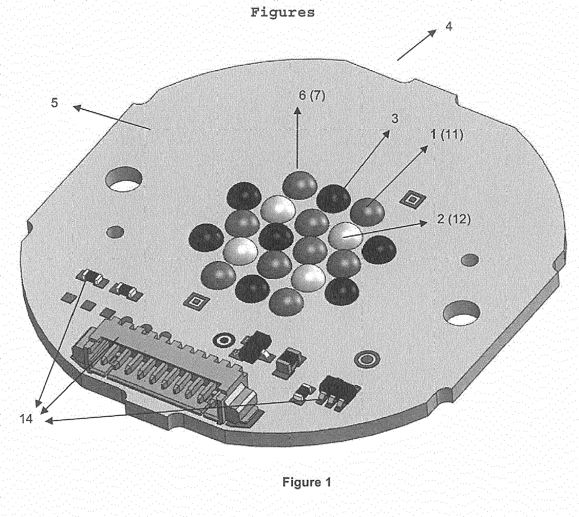

In Figure 1 shows a white light emitting LED-module 4 according to the first aspect of the invention with nine first blue LEDs 1, four second blue LEDs 2 and seven red LEDs 3. The particular LEDs are not shown in Figure 1. The LEDs 1, 2, 3 are positioned under the color conversion means 6. This arrangement represents an example according to the first aspect of the invention. The number of the applied LEDs is not limited to cited example. Preferably, the ratio of the first blue LEDs 1 to the second blue LEDs 2 and to red LEDs 3 is between 2:2:1 and 4:4:1, respectively. In a possible arrangement according to the invention there are 16 first blue LEDs 1, 16 second blue LEDs 2 and 5 red LEDs 3 positioned on the substrate 5. Said arrangement represents a 3.2:3.2:1 ratio. Further possible setups could be realised through the following examples 4-40 pieces of first blue LEDs 1, 4-40 pieces of second blue LEDs 2 and 2-20 pieces of red LEDs 3.

The LEDs 1, 2, 3 are mounted onto a substrate 5 (e.g. Printed Circuit Board (PCB), board), preferable onto a flat substrate 5 by a die attach means (e.g. soldering, gluing).

The LED-module(s) 4 comprises preferably at least a first blue LEDs 1, a second blue LEDs 2 and a red LED 3 under separated color conversion means 6. As it is illustrated by Figure 1 the color conversion means could be a dome-shaped encapsulation element(s) such as a globe-top(s) 7.

The LED-module is preferably a COB (Chip-On-Board)-module. The first, second blue LEDs 1, 2 and the red LEDs 3 are connected in series to each other in separated strings. The strings are parallely connected to each other and are separately drivable. Driving parameters are separately adjustable to reach the targeted CCT and/or CRI values. The LEDs can be connected to the electrical paths/conductive pads of the substrate by e.g. bonding wires and/or by solder bumps. Instead of LED Dice (LED-Chips) SMD (Surface Mounted Device, LED-package) LEDs could be also applied onto the substrate 5.

The color conversion means 6 is applied onto the LEDs 1, 2, 3 as a transparent encapsulation in a form of a globe-top 7 (half-spherical element). However, the invention is not limited to the above mentioned form of encapsulation but could be in any possible form carried out such as cubic-shaped or a "thin" phosphor layer.

The color conversion means 6 comprises a polymer matrix e.g. silicone resin, epoxy resin or a resin mixture of said materials or any other suitable polymer(s) (e.g. PMMA) and a phosphor (s) (or any kind of other color conversion means). Preferably, a scattering material(s) (e.g. SiO₂, TiO₂, BaTiO₃, BaSO₄, ZrO₂, ZnO, Al₂O₃) and/or agents and/or filler particles (e.g. SiO₂, silica gel, TiO₂, BaTiO₃, BaSO₄, ZrO₂, ZnO, Al₂O₃) are applied in the polymer matrix to adjust the rheological properties of the used dispersion(s). Preferably, the transparent encapsulation matrices 6 (globe-tops) comprise 6-9 wt% phosphor, more preferably 7-8 wt% phosphor.

Preferably, the first and second blue LEDs 1, 2 are covered by a color conversion means 6. The assembly of the blue LEDs 1, 2 and of the color conversion means 6 is resulted in color converted first and second blue LEDs 11, 12. A globe-top 7 comprising a phosphor (s) is applied to each of the LEDs 1, 2. The same or different phosphor(s) could be applied onto the first and second blue LEDs 1, 2 to convert the emitted blue light into a longer wavelength one(s). Any commercially available phosphor or a mixture of the ones could be applied according the invention. Preferably, in the green, yellow-green or yellow wavelength range emitting phosphors (garnets, oxides, silicates etc.) are incorporated into the globe-tops 7.

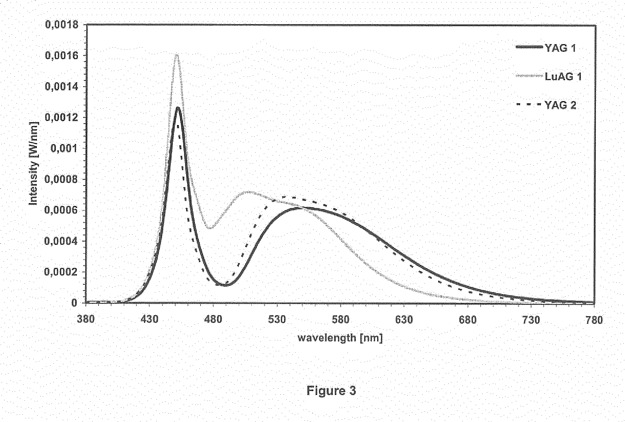

The emitted spectra of the color converted first and second blue LEDs 11, 12 could be substantially different as it is illustrated by examples of Figure 3.

Preferably, the red LEDs 3 are incorporated into the encapsulation matrices comprising no color conversion means, preferably some scattering agents and/or filler particles are intercalated into the matrices to enhance the homogeneity of the emitted light. The most frequently applied phosphors, which have an emission peak in green, yellow-green or yellow wavelength region of the visible spectrum, are not excitable by red light. The usage of the latter phosphors could be considered in the globe-tops 7 covering the red LEDs 3, as well.

Preferably, the upper side of the substrate 5 is coated with a highly reflective coating layer comprising nonconductive reflective particles e.g. TiO₂, BaSO₄, ZrO₂, BaTiO₃, Al₂O₃ or alternatively a metal layer (e.g. Al, Ag, Au with or without any protecting oxide layer(s) and/or polymer layer(s) on the top) can be applied onto the substrate 5.

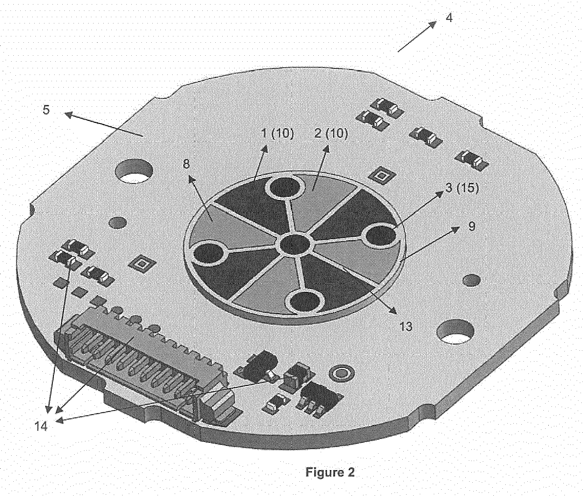

Further elements 14 such as parts of the driving electronics e.g. microcontrollers, capacitors, inductors, resistors, supplying cables could be mounted onto the LED-module 4 as it is illustrated on Figure 1 and 2.

In Figure 2 illustrates an LED-module 4 according to another aspect of the invention. The first and second blue LEDs 1, 2 are positioned under the common transparent encapsulation elements 10, which are formed as coating layers 8 on the LEDs 1, 2 and are surrounded by a dam 9. Dam 9 is a highly reflective frame used as a reflector and as a flow-stopping means for the encapsulation matrix(es).

Preferably, the coating layers 8 are directly dispensed onto the first and second blue LEDs 1, 2. Color conversion means 6 (e.g. phosphors) described in case of the embodiment according to Figure 1 could be applied in the arrangement shown in Figure 2.

Red LEDs 3 are positioned under the encapsulation matrices 8, which could be applied as globe-tops 7, coating layers 8 or common encapsulation elements 15 with or without any color conversion means. Preferably the coating layers 8 incorporating the red LEDs 3 comprise scattering and/or filler particles.

Figure 2 shows 8 "larger" common encapsulation elements 10 and 5 "smaller" common encapsulation elements 15 separated by inner walls 13 inside the dam 9. Under each "larger" common encapsulation elements 10, could be one or a plurality of first or second LEDs 1, 2 located. Under each "smaller" common encapsulation elements 15 are the red LEDs 3 positioned. The encapsulation matrix 15 covering the red LED(s) 3 either does not comprise a color conversion means 6 or such a phosphor is applied, which does not convert the emitted spectrum of the red LED(s) 3 into another wavelength range, but the emitted spectrum remains substantially the same.

Each common encapsulation element 10, 15 could be dedicated for a different emission spectrum. E.g. the common encapsulation element 10 covering the first blue LED(s) 1 emits a spectrum which is substantially different than the one emitted by the common encapsulation element 10 positioned on the second blue LED(s) 2. Preferably, there are 3 substantially different light spectra emitted by the light emitting fields formed by said common encapsulation elements 10, 15 and the blue and red LEDs 1, 2, 3 applied onto the LED-module 4, which are observed as white light as a sum by the human eye.

Some possible examples of said spectra emitted by the color converted first and second blue LEDs 11, 12 (or as a sum by the first and second blue LEDs 1, 2 and the common encapsulation means 10) are illustrated on Figure 3. The spectrum "LuAG 1" represent the emission spectrum of color converted first blue LED(s) 11. "YAG 1" and "YAG 2" illustrate the spectra of the emitted light by the color converted second blue LED(s) 12 according to one aspect of the invented solution. In this particular example the first blue LED(s) 1 is/are covered by a color conversion means 6 comprising a garnet phosphor, namely a Lu₃Al₅O₁₂: Ce³⁺ (LuAG: Ce³⁺). A different type of garnet phosphor e.g. Y₃Al₅O₁₂ : Ce³⁺ (YAG: Ce³⁺)could be applied as color conversion means 6 to the second blue LED(s) 2. Emission spectra generated by the second color converted blue LED(s) 12 comprising two different commercially available Y₃Al₅O₁₂: Ce³⁺ phosphors are illustrated by the curves "YAG 1" and "YAG 2". Applicable Y₃Al₅O₁₂ : Ce³⁺ phosphors have an emission peak between 520 and 560nm with FWHM bigger than 110nm, typically 112-120nm. FWHM values of the curves "YAG 1" and "YAG 2" are about 118 and 114, respectively. Commercially available Lu₃Al₅O₁₂ : Ce³⁺ phosphors show overlapping emission peaks between 500-520nm and 530-550nm as it is illustrated by the curve " LuAG 1".

The d50 values of applied garnet phosphors (YAG: Ce³⁺, LuAG: Ce³⁺) are preferably in the range of 10-25micron, more preferably 12-21micron. The rare earth dopant concentration is about 0.01-0.2 (e.g. Lu_{2.9}Al₅O₁₂ : 0.1Ce³⁺).

**Table 1:**

| | **3 Channel Solution (Prior art)** | | | | | | |
|---|---|---|---|---|---|---|---|
| | **λ Dom [nm]** | **Radiant Power** | **Phosphor** | **CIE-x-Min** | **CIE-x-Max** | **CIE-y-Min** | **CIE-y-Max** |
| **LED 1** | 465-475 | 340 - 380 mW | - | - | - | - | - |
| **LED 2** | 450-460 | 420 - 440 mW | YAG: Ce³⁺ | 0.395 | 0.415 | 0.490 | 0.555 |
| **LED 3** | 615-617.5 | >17 cd | - | - | - | - | - |

Table 1 illustrates a 3 channel solution according to the prior art (known from e.g. WO2009033642A1).

**Table 2:**

| | **3 Channel solution (Invented)** | | | | | | |
|---|---|---|---|---|---|---|---|
| | **λ Dom [nm]** | **Radiant Power** | **Phosphor** | **CIE-x-Min** | **CIE-x-Max** | **CIE-y-Min** | **CIE-y-Max** |
| **LED 1** | 452.5-455 | 216 mW | LuAG: Ce³⁺ | - | - | 0.2409 | 0.2498 |
| **LED 2** | 450-455 | 216 mW | YAG:Ce³⁺ | 0.395 | 0.415 | 0.490 | 0.555 |
| | 455-460 | 216 mW | LuAG1+YAG1, LuAG1+LuAG2, YAG1+YAG2 | | | | |
| **LED 3** | 615-617.5 | >17 cd | - | - | - | - | - |

Table 2 illustrates some possible embodiments according to the invented 3 channel solution.

Color triangles according to the prior art (CRT gamut (sRGB) and Blue + Phosphor converted Blue (White) + Red) and to the invented solution(s) are illustrated on the CIE Chromaticity Diagram 1931 as monitored by Figure 4. The Plankian curve (full radiator locus, black body curve) is represented by a continuous black line in the middle of the diagram.

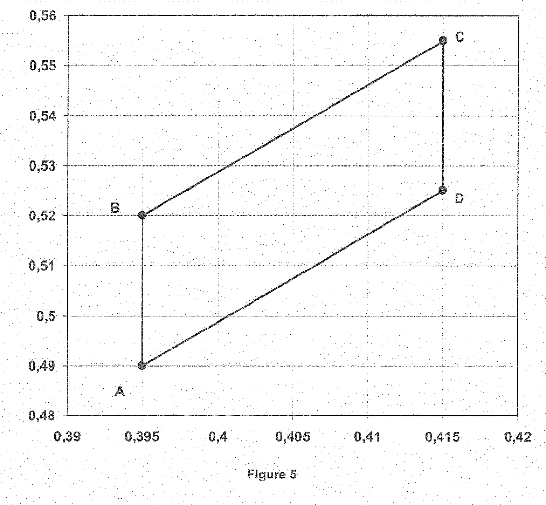

Figure 5 shows the color point of the color converted second blue LED(s) 12 according to the invention, which should be located inside or at the border line of the rectangle defined by the following corner points x=0.395, y=0.490, x=0.395, y=0.520, x=0.415, y=0.525 and x=0.415, y=0.555 on the 1931 CIE Chromaticity Diagram according to one aspect of the invention. Said x and y values are chromaticity coordinates. If the color point of the color converted second blue LED(s) is not inside or at the border line of said rectangle, the targeted higher than 90 CRI values cannot be reached in the full range of 2500-9000K (or 2700-6500K) .

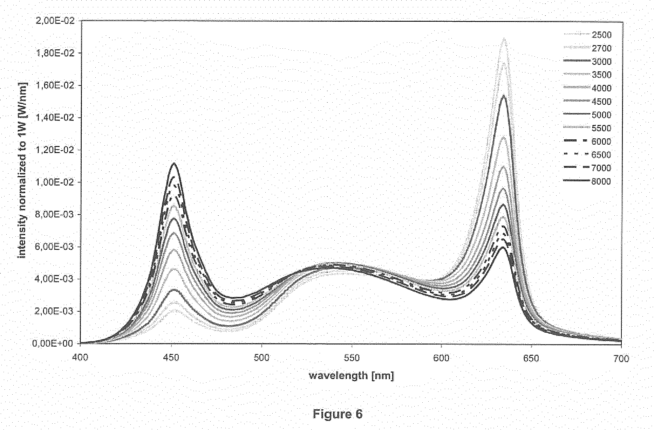

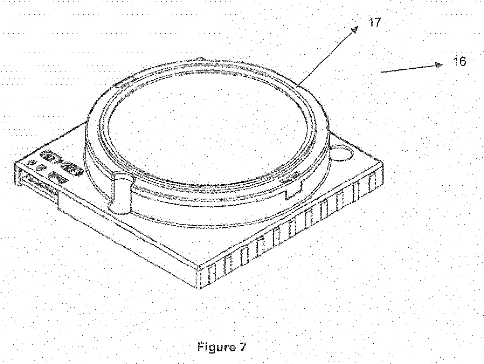

Figure 6 shows some emission curves in the 2500-8000K range of the invented LED-modules 4. Said curves illustrate the emission spectra, which are mixtures of the lights emitted by the applied first, second blue LEDs 1, 2; the red LEDs 3 and the color conversion means 6. The LED-module 4 emits white light with a CRI value higher than 90 in the color temperature (CCT) range of 2500-8000K. The emission spectra between 400-700nm provide three peaks, namely one in each range of 440-460nm, 520-570nm and 620-640nm. This invented embodiment comprises color converted first blue LEDs 1 and color converted second blue LEDs 2 having a color point of x=0.2253, y=0.2409 and x=0.4150, y=0.5069. The dominant wavelength of the applied red LEDs is 616nm. As color conversion means 6 a LuAG: Ce³⁺ was used to the first blue LEDs 1 and YAG: Ce³⁺ to the second blue LEDs 2. In a specially preferred embodiment, a LED light engine arrangement 16 illustrated as an example by Figure 7 according to the invention, comprises an LED-module 4 according to the invention incorporated into a housing 17. Said arrangement 16 could be applied for any illumination purposes.

The invention is defined by the appended claims.

### List of reference numbers:

- 1: First Blue LED
- 2: Second Blue LED
- 3: Red LED
- 4: LED-module
- 5: Substrate
- 6: Color conversion means
- 7: Globe-top
- 8: Coating layer
- 9: Dam
- 10: Larger common encapsulation element
- 11: Color converted first blue LED
- 12: Color converted second blue LED
- 13: Inner wall
- 14: Further parts
- 15: Smaller common encapsulation element
- 16: LED light engine arrangement
- 17: Housing

## Claims

1. A white light emitting LED-module, comprising:
- at least two blue LEDs,
- a red LED, mounted onto a substrate and a color conversion means,
wherein the color conversion means is applied to the first and to a second blue LED of the at least two blue LEDs,
**characterized in that**
the dominant wavelength of the first blue LED is between 451nm and 457nm, preferably between 452.5nm and 455nm, and the dominant wavelength of the red LED is between 610nm and 620nm, preferably between 612nm and 618nm, more preferably between 615nm and 617.5nm,
and **in that**
the color point of the second color converted blue LED is located within or on the borderline of the rectangular area defined by the corner points of x=0.395, y=0.490; x=0.395, y=0.520; x=0.415, y=0.525 ; and x=0.415, y=0.555 on the 1931 CIE Chromaticity Diagram.

2. White light emitting LED-module according to claim 1,
wherein the color rendering index (CRI) of the emitted white light is at least 90 and the correlated color temperature (CCT) of the emitted white light is in the range of 2500K-8000K, more preferably between 2700K and 6500K.

3. White light emitting LED-module according to claim 1 or 2,
wherein the dominant wavelength of the second blue LED is between 440nm and 470nm, preferably between 450nm and 460nm.

4. White light emitting LED-module according to claim 1 to 3,
wherein the dominant wavelength of the second blue LED is between 445nm and 460nm or between 450nm and 465nm, preferably between 450nm and 455nm or between 455nm and 460nm.

5. White light emitting LED-module according to claim 1 to 4,
wherein the value of the y chromaticity coordinate of the first color converted blue LED is between 0.2350 and 0.2550, preferably between 0.2409 and 0.2498.

6. White light emitting LED-module according to claim 1 to 5,
wherein the value of the y chromaticity coordinate of the second color converted blue LED is between 0.4750 and 0.5700, preferably between 0.4800 and 0.5650, more preferably between 0.4900 and 0.5550.

7. White light emitting LED-module according to claim 1 to 6,
wherein the value of the x chromaticity coordinate of the second color converted blue LED is between 0.370 and 0.440, preferably between 0.385 and 0.425, more preferably between 0.395 and 0.420.

8. White light emitting LED-module according to claim 1 to 7, wherein the color conversion means is selected from the group of inorganic phosphors, organic phosphors and quantum dots.

9. White light emitting LED-module according to any of the preceding claims, wherein the color conversion means shows an emission peak between 505 and 580nm, more preferably between 510 and 560nm and the emission peak has a FWHM of 55-120nm, more preferably 65-110nm.

10. White light emitting LED-module according to any of the preceding claims, wherein the color conversion means has two emission peaks in the range of 505-580nm, more preferably between 510-560nm.

11. White light emitting LED-module according to claim 9 or 10, wherein the color conversion means is selected from the group of garnets, aluminates, silicates, ortho-silicates, oxides, SiALONs, nitrides, oxy-nitrides.

12. White light emitting LED-module according to claim 11, wherein the color conversion means has a garnet structure comprising Yttrium and/or Lutetium and/or Gadolinium and rare earth metal ion(s) as dopant(s) and/or sentisizer(s).

13. White light emitting LED-module according to claim 11, wherein a mixture of color conversion means comprising a luminophor(s) having a garnet structure based on the main components Yttrium and/or Lutetium and/or Gadolinium and rare earth metal ion(s) as dopant(s) and/or sentisizer is applied to the LEDs.

14. White light emitting LED-module according to any of the preceding claims, wherein the LED-module comprises a plurality of blue LEDs and a plurality of red LEDs.

15. White light emitting LED-module according to any of the preceding claims, wherein the ratio of the first blue LEDs 1 to the second blue LEDs 2 and to red LEDs 3 is between 2:2:1 and 4:4:1.

16. White light emitting LED-module according to any of the preceding claims, wherein the blue LEDs have a radiant power of 100-400mW.

17. White light emitting LED-module according to any of the preceding claims, wherein the red LED has a minimum luminous intensity of 15cd, preferably 17cd.

18. White light emitting LED-module according to any of the preceding claims, wherein the LED-module is a COB-module.

19. White light emitting LED-module according to any of the preceding claims, wherein the LEDs are covered by a common or individual color conversion layer(s) comprising color conversion means.

20. White light emitting LED-module according to any of the preceding claims, wherein the color conversion layer(s) comprises filler and/or scattering agent(s).

21. White light emitting LED-module according to any of the preceding claims, wherein the color conversion layer is globe-top.

22. A method for providing a white light emitting LED-module, comprising the steps of
- mounting of at least two blue LEDs and
- a red LED, and onto a substrate, and
- applying a color conversion means to a first and to a second LED of the at least two blue LEDs, **characterized in that**
the dominant wavelength of the first blue LED is between 451nm and 457nm, preferably between 452.5nm and 455nm, and the dominant wavelength of the red LED is between 610 nm and 620nm, preferably between 612 nm and 618nm, more preferably between 615nm and 617.5nm, and wherein the color point of the second color converted blue LED is located within or on the borderline of the rectangular area defined by the corner points of x=0.395, y=0.490; x=0.395, y=0.520; x=0.415, y=0.525; and x=0.415, y=0.555 on the 1931 CIE Chromaticity Diagram.

## Patentansprüche

1. Weißlicht emittierendes LED-Modul, umfassend:
- mindestens zwei blaue LEDs,
- eine rote LED, auf einem Substrat montiert, und ein Farbkonvertierungsmittel,
wobei das Farbkonvertierungsmittel auf die erste und auf eine zweite blaue LED der mindestens zwei blauen LEDs aufgebracht ist,
**dadurch gekennzeichnet, dass**
die dominante Wellenlänge der ersten blauen LED zwischen 451 nm und 457 nm liegt, vorzugsweise zwischen 452,5 nm und 455 nm, und die dominante Wellenlänge der roten LED zwischen 610 nm und 620 nm liegt, vorzugsweise zwischen 612 nm und 618 nm, mit besonderem Vorzug zwischen 615 nm und 617,5 nm,
und dass
sich der Farbpunkt der zweiten farbkonvertierten blauen LED innerhalb oder auf der Grenzlinie des rechteckigen Bereichs befindet, der von den Eckpunkten von x = 0,395, y = 0,490; x = 0,395, y = 0,520; x = 0,415, y = 0,525; und x = 0,415, y = 0,555 auf dem CIE-1931-Chromatizitätsdiagramm definiert ist.

2. Weißlicht emittierendes LED-Modul nach Anspruch 1, wobei der Farbwiedergabeindex (CRI) des emittierten Weißlichts mindestens 90 beträgt und die korrelierte Farbtemperatur (CCT) des emittierten Weißlichts im Bereich von 2500 K-8000 K liegt, mit besonderem Vorzug zwischen 2700 K und 6500 K.

3. Weißlicht emittierendes LED-Modul nach Anspruch 1 oder 2,
wobei die dominante Wellenlänge der zweiten blauen LED zwischen 440 nm und 470 nm liegt, vorzugsweise zwischen 450 nm und 460 nm.

4. Weißlicht emittierendes LED-Modul nach Anspruch 1 bis 3,
wobei die dominante Wellenlänge der zweiten blauen LED zwischen 445 nm und 460 nm oder zwischen 450 nm und 465 nm liegt, vorzugsweise zwischen 450 nm und 455 nm oder zwischen 455 nm und 460 nm.

5. Weißlicht emittierendes LED-Modul nach Anspruch 1 bis 4,
wobei der Wert der y-Chromatizitätskoordinate der ersten farbkonvertierten blauen LED zwischen 0,2350 und 0,2550 liegt, vorzugsweise zwischen 0,2409 und 0,2498.

6. Weißlicht emittierendes LED-Modul nach Anspruch 1 bis 5,
wobei der Wert der y-Chromatizitätskoordinate der zweiten farbkonvertierten blauen LED zwischen 0,4750 und 0,5700 liegt, vorzugsweise zwischen 0,4800 und 0,5650, mit besonderem Vorzug zwischen 0,4900 und 0,5550.

7. Weißlicht emittierendes LED-Modul nach Anspruch 1 bis 6,
wobei der Wert der x-Chromatizitätskoordinate der zweiten farbkonvertierten blauen LED zwischen 0,370 und 0,440 liegt, vorzugsweise zwischen 0,385 und 0,425, mit besonderem Vorzug zwischen 0,395 und 0,420.

8. Weißlicht emittierendes LED-Modul nach Anspruch 1 bis 7, wobei das Farbkonvertierungsmittel ausgewählt ist aus der Gruppe von anorganischen Leuchtstoffen, organischen Leuchtstoffen und Quantenpunkten.

9. Weißlicht emittierendes LED-Modul nach einem der vorhergehenden Ansprüche, wobei das Farbkonvertierungsmittel eine Emissionsspitze zwischen 505 und 580 nm aufweist, mit besonderem Vorzug zwischen 510 und 560 nm, und die Emissionsspitze eine Halbwertsbreite (FWHM) von 55-120 nm aufweist, mit besonderem Vorzug 65-110 nm.

10. Weißlicht emittierendes LED-Modul nach einem der vorhergehenden Ansprüche, wobei das Farbkonvertierungsmittel zwei Emissionsspitzen im Bereich von 505-580 nm aufweist, mit besonderem Vorzug zwischen 510-560 nm.

11. Weißlicht emittierendes LED-Modul nach Anspruch 9 oder 10, wobei das Farbkonvertierungsmittel ausgewählt ist aus der Gruppe von Granaten, Aluminaten, Silikaten, Ortho-Silikaten, Oxiden, SiALONs, Nitriden, Oxynitriden.

12. Weißlicht emittierendes LED-Modul nach Anspruch 11, wobei das Farbkonvertierungsmittel eine Granatstruktur umfassend Yttrium und/oder Lutetium und/oder Gadolinium und Seltenerdmetallion(en) als Dotierungsmittel und/oder Sensibilisator(en) aufweist.

13. Weißlicht emittierendes LED-Modul nach Anspruch 11, wobei eine Mischung aus Farbkonvertierungsmittel einen Luminophor mit einer Granatstruktur auf der Basis der Hauptkomponenten Yttrium und/oder Lutetium und/oder Gadolinium aufweist und Seltenerdmetallion(en) als Dotierungsmittel und/oder Sensibilisator auf den LEDs aufgebracht sind.

14. Weißlicht emittierendes LED-Modul nach einem der vorhergehenden Ansprüche, wobei das LED-Modul mehrere blaue LEDs und mehrere rote LEDs umfasst.

15. Weißlicht emittierendes LED-Modul nach einem der vorhergehenden Ansprüche, wobei das Verhältnis der ersten blauen LEDs 1 zu den zweiten blauen LEDs 2 und zu roten LEDs 3 zwischen 2:2:1 und 4:4:1 liegt.

16. Weißlicht emittierendes LED-Modul nach einem der vorhergehenden Ansprüche, wobei die blauen LEDs eine Strahlungsleistung von 100-400 mW aufweisen.

17. Weißlicht emittierendes LED-Modul nach einem der vorhergehenden Ansprüche, wobei die rote LED eine Mindestlichtstärke von 15 cd aufweist, vorzugsweise 17 cd.

18. Weißlicht emittierendes LED-Modul nach einem der vorhergehenden Ansprüche, wobei das LED-Modul ein COB-Modul ist.

19. Weißlicht emittierendes LED-Modul nach einem der vorhergehenden Ansprüche, wobei die LEDs von einer gemeinsamen oder individuellen Farbkonvertierungsschicht(en) umfassend Farbkonvertierungsmittel bedeckt sind.

20. Weißlicht emittierendes LED-Modul nach einem der vorhergehenden Ansprüche, wobei die Farbkonvertierungsschicht(en) Füllstoff und/oder Streumittel umfassen.

21. Weißlicht emittierendes LED-Modul nach einem der vorhergehenden Ansprüche, wobei die Farbkonvertierungsschicht ein Globe Top ist.

22. Verfahren zur Bereitstellung eines Weißlicht emittierenden LED-Moduls, umfassend die Schritte
- Montieren von mindestens zwei blauen LEDs und
- einer roten LED auf einem Substrat, und
- Aufbringen eines Farbkonvertierungsmittels auf eine erste und auf eine zweite LED der mindestens zwei blauen LEDs,
**dadurch gekennzeichnet, dass**
die dominante Wellenlänge der ersten blauen LED zwischen 451 nm und 457 nm liegt, vorzugsweise zwischen 452,5 nm und 455 nm, und die dominante Wellenlänge der roten LED zwischen 610 nm und 620 nm liegt, vorzugsweise zwischen 612 nm und 618 nm, mit besonderem Vorzug zwischen 615 nm und 617,5 nm, und wobei sich der Farbpunkt der zweiten farbkonvertierten blauen LED innerhalb oder auf der Grenzlinie des rechteckigen Bereichs befindet, der von den Eckpunkten von x = 0,395, y = 0,490; x = 0,395, y = 0,520; x = 0,415, y = 0,525; und x = 0,415, y = 0,555 auf dem CIE-1931-Chromatizitätsdiagramm definiert ist.

## Revendications

1. Module à DEL émettant de la lumière blanche, comprenant :
- au moins deux DEL bleues,
- une DEL rouge, montée sur un substrat et un moyen de conversion de couleur,
dans lequel le moyen de conversion de couleur est appliqué à la première et à une seconde DEL bleue des au moins deux DEL bleues,
**caractérisé en ce que**
la longueur d'onde dominante de la première DEL bleue est comprise entre 451 nm et 457 nm, de préférence entre 452,5 nm et 455 nm, et la longueur d'onde dominante de la DEL rouge est comprise entre 610 nm et 620 nm, de préférence entre 612 nm et 618 nm, idéalement entre 615 nm et 617,5 nm,
et **en ce que**
le point de couleur de la seconde DEL bleue à couleur convertie est situé à l'intérieur ou à la limite de la zone rectangulaire définie par les points d'angle x = 0,395, y = 0,490 ; x = 0,395, y = 0,520 ; x = 0,415, y = 0,525 et x = 0,415, y = 0,555 sur le diagramme de chromaticité CIE 1931.

2. Module à DEL émettant de la lumière blanche selon la revendication 1,
dans lequel l'indice de rendu des couleurs (CRI) de la lumière blanche émise est d'au moins 90 et la température de couleur corrélée (CCT) de la lumière blanche émise est comprise entre 2500 K et 8000 K, idéalement entre 2700 K et 6500 K.

3. Module à DEL émettant de la lumière blanche selon la revendication 1 ou 2,
dans lequel la longueur d'onde dominante de la seconde DEL bleue est comprise entre 440 nm et 470 nm, de préférence entre 450 nm et 460 nm.

4. Module à DEL émettant de la lumière blanche selon les revendications 1 à 3,
dans lequel la longueur d'onde dominante de la seconde DEL bleue est comprise entre 445 nm et 460 nm ou entre 450 nm et 465 nm, de préférence entre 450 nm et 455 nm ou entre 455 nm et 460 nm.

5. Module à DEL émettant de la lumière blanche selon les revendications 1 à 4,
dans lequel la valeur de la coordonnée de chromaticité y de la première DEL bleue à couleur convertie est comprise entre 0,2350 et 0,2550, de préférence entre 0,2409 et 0,2498.

6. Module à DEL émettant de la lumière blanche selon les revendications 1 à 5,
dans lequel la valeur de la coordonnée de chromaticité y de la seconde DEL bleue à couleur convertie est comprise entre 0,4750 et 0,5700, de préférence entre 0,4800 et 0,5650, idéalement entre 0,4900 et 0,5550.

7. Module à DEL émettant de la lumière blanche selon les revendications 1 à 6,
dans lequel la valeur de la coordonnée de chromaticité x de la seconde DEL bleue à couleur convertie est comprise entre 0,370 et 0,440, de préférence entre 0,385 et 0,425, idéalement entre 0,395 et 0,420.

8. Module à DEL émettant de la lumière blanche selon les revendications 1 à 7, dans lequel le moyen de conversion de couleur est choisi dans le groupe des phosphores non organiques, des phosphores organiques et des points quantiques.

9. Module à DEL émettant de la lumière blanche selon une quelconque des revendications précédentes, dans lequel le moyen de conversion de couleur présente une crête d'émission entre 505 et 580 nm, idéalement entre 510 et 560 nm et la crête d'émission a un FWHM de 55-120 nm, idéalement de 65-110 nm.

10. Module à DEL émettant de la lumière blanche selon une quelconque des revendications précédentes, dans lequel le moyen de conversion de couleur a deux pics d'émission dans la gamme de 505 à 580 nm, idéalement entre 510 et 560 nm.

11. Module à DEL émettant de la lumière blanche selon la revendication 9 ou 10, dans lequel le moyen de conversion de couleur est choisi dans le groupe constitué par les grenats, les aluminates, les silicates, les ortho-silicates, les oxydes, les SiALON, les nitrures, les oxy-nitrures.

12. Module à DEL émettant de la lumière blanche selon la revendication 11, dans lequel le moyen de conversion de couleur a une structure de grenat comprenant un ou plusieurs ions d'yttrium et/ou de lutétium et/ou de gadolinium et de métaux du groupe des terres rares utilisés comme dopants et/ou sensibilisants.

13. Module à DEL émettant de la lumière blanche selon la revendication 11, dans lequel un mélange de moyens de conversion de couleur comprenant un ou plusieurs luminophores ayant une structure de grenat basée sur les composants principaux d'un ou plusieurs ions d'yttrium et/ou de lutétium et/ou de gadolinium et de métaux du groupe des terres rares en tant que dopants et/ou sensibilisants est appliqué aux DEL.

14. Module à DEL émettant de la lumière blanche selon une quelconque des revendications précédentes, dans lequel le module à DEL comprend une pluralité de DEL bleues et une pluralité de DEL rouges.

15. Module à DEL émettant de la lumière blanche selon une quelconque des revendications précédentes, dans lequel le rapport des premières DEL bleues 1 aux secondes DEL bleues 2 et aux DEL rouges 3 est compris entre 2:2:1 et 4:4:1.

16. Module à DEL émettant de la lumière blanche selon une quelconque des revendications précédentes, dans lequel les DEL bleues ont une puissance d'irradiation de 100 à 400 mW.

17. Module à DEL émettant de la lumière blanche selon une quelconque des revendications précédentes, dans lequel la DEL rouge a une intensité lumineuse minimale de 15 cd, de préférence de 17 cd.

18. Module à DEL émettant de la lumière blanche selon une quelconque des revendications précédentes, dans lequel le module à DEL est un module COB.

19. Module à DEL émettant de la lumière blanche selon une quelconque des revendications précédentes, dans lequel les DEL sont couvertes par une ou plusieurs couches de conversion de couleurs communes ou individuelles comprenant un moyen de conversion de couleurs.

20. Module à DEL émettant de la lumière blanche selon une quelconque des revendications précédentes, dans lequel la ou les couches de conversion de couleur comprennent un élément de remplissage et/ou un ou plusieurs agents de diffusion.

21. Module à DEL émettant de la lumière blanche selon une quelconque des revendications précédentes, dans lequel la couche de conversion de couleur est le sommet d'un globe.

22. Procédé de réalisation d'un module à DEL émettant de la lumière blanche, comprenant les étapes suivantes :
- montage d'au moins deux DEL bleues et
- une DEL rouge et sur un substrat, et
- application d'un moyen de conversion de couleur à une première et à une seconde DEL des au moins deux DEL bleues,
**caractérisé en ce que**
la longueur d'onde dominante de la première DEL bleue est comprise entre 451 nm et 457 nm, de préférence entre 452,5 et 455 nm, et la longueur d'onde dominante de la DEL rouge est comprise entre 610 nm et 620 nm, de préférence entre 612 nm et 618 nm, idéalement entre 615 nm et 617,5 nm, et dans lequel le point de couleur de la seconde DEL bleue à couleur convertie est situé à l'intérieur ou à la limite de la zone rectangulaire définie par les points d'angle x = 0,395, y = 0,490 ; x = 0,395, y = 0,520 ; x = 0,415, y = 0,525 et x = 0,415, y = 0,555 sur le diagramme de chromaticité CIE 1931.
